(19) Europäisches Patentamt
European Patent Office
Office européen des brevets

(11) **EP 1 330 905 B1**

(12) **EUROPEAN PATENT SPECIFICATION**

(45) Date of publication and mention
of the grant of the patent:
**19.12.2007 Bulletin 2007/51**

(51) Int Cl.:
***H04L 27/36*** (2006.01)       ***H03B 27/00*** (2006.01)

(21) Application number: **00976923.3**

(22) Date of filing: **03.11.2000**

(86) International application number:
**PCT/US2000/030406**

(87) International publication number:
**WO 2002/037787 (10.05.2002 Gazette 2002/19)**

(54) **MODULATOR WITH LOW SENSITIVITY TO AMPLITUDE AND PHASE ERRORS OF THE CARRIER SIGNAL**

MODULATOR MIT GERINGER EMPFINDLICHKEIT BEI AMPLITUDEN- UND PHASENFEHLERN VOM TRÄGERSIGNAL

MODULATEUR AYANT UNE SENSIBILITE REDUITE A L'AMPLITUDE ET AUX ERREURS DE PHASE DU SIGNAL DE PORTEUSE

(84) Designated Contracting States:
**AT BE CH CY DE DK ES FI FR GB GR IE IT LI LU MC NL PT SE TR**

(43) Date of publication of application:
**30.07.2003 Bulletin 2003/31**

(60) Divisional application:
**07019275.2**

(73) Proprietor: **QUALCOMM INCORPORATED**
**San Diego, CA 92121-1714 (US)**

(72) Inventor: **SAHOTA, Kamal, Gurkanwal**
**San Diego, CA 92103 (US)**

(74) Representative: **Wagner, Karl H.**
**Wagner & Geyer**
**Patentanwälte**
**Gewürzmühlstrasse 5**
**80538 München (DE)**

(56) References cited:
**DE-C- 19 934 215**       **US-A- 5 111 155**
**US-A- 5 412 351**       **US-A- 5 438 301**
**US-A- 5 705 958**

**Description**

**BACKGROUND OF THE INVENTION**

**I. Field of the Invention**

The present invention relates to communications systems. More particularly, the present invention relates to novel and improved quadrature modulators and demodulators for communications systems.

**II. Description of the Related Art**

In many modern communications systems, digital transmission is utilized because of improved efficiency and enhanced performance. Examples of digital transmission formats include binary phase shift keying (BPSK), quaternary phase shift keying (QPSK), offset quaternary phase shift keying (OQPSK), m-ary phase shift keying (m-PSK), and quadrature amplitude modulation (QAM). Examples of communications systems that utilize digital transmission include code division multiple access (CDMA) communications systems and high definition television (HDTV) systems.

In typical digital communications systems, the signal to be transmitted is digitally generated and initially processed at baseband. The baseband processing can include buffering, filtering, and amplification. The processed baseband signal is then modulated to an intermediate frequency (IF) where additional signal processing (i.e., buffering, filtering, amplification, and so on) can be performed. The modulated and processed IF signal is upconverted to radio frequency (RF), further processed, and transmitted.

At a receiver, the transmitted RF signal is received, processed (i.e., amplified and filtered), and downconverted to an IF frequency (that may or may not match the IF frequency at the transmitter). The IF signal is then demodulated using a demodulation scheme complementary to the modulation scheme used at the transmitter.

In many conventional transmitter and receiver architectures, the modulation and demodulation are performed using analog circuitry. In a comnon modulator architecture, the baseband I and Q signals are provided to a pair of mixers that also respectively receive an inphase carrier signal (I LO) and a quadrature carrier signal (Q LO). The first mixer modulates the I LO with the I signal to generate the I modulated component, and the second mixer modulates the Q LO with the Q signal to generate the Q modulated component. The I and Q modulated components are then combined by a summer to generate the modulated signal.

This simplified modulator provides acceptable performance when the I LO and Q LO are properly generated (i.e., having amplitude and phase errors within specified limits). These carrier signals are typically generated by analog circuitry, such as a phase shift network or a phase splitter, which invariably exhibits some amounts of error due to various factors such as component tolerance, component mismatch, and so on. The amplitude and/or phase error in these carrier signals produce I and Q modulated components that are not in quadrature (i.e., not 90° out-of-phase between the signals) and not amplitude balanced. The errors in the modulated components can result in performance degradation at the receiver that locks to, and demodulates the received modulated signal. Such degradation can include poor image rejection, residual phase error in the carrier tracking loop, cross-talk between the demodulated I and Q components, and others.

Accordingly, modulators and demodulators that are more insensitive to amplitude and/or phase error in the carrier signals are highly desirable. It is also desirable that the modulators and demodulators be more insensitive to gain and phase errors in the mixers and other circuits that make up these modulators and demodulators.

Attention is drawn to document US-A-5 438 301, which discloses a carrier generator circuit for use in a modem employed in a wireless communication system is described. The carrier generator circuit includes a voltage controlled oscillator comprising an N-stage ring oscillator to generate N balanced vectors of equal magnitude and arbitrary phase difference. The carrier generator circuit also includes a phase corrector to add two of the balanced vectors to generate a sum vector and to subtract the two balanced vectors to generate a difference vector. The sum vector and difference vector have a phase difference of 90 degrees. The sum vector represents an I (in-phase) carrier signal component and the difference vector represents a Q (quadrature-phase) carrier signal component. These I and Q carrier signal components can be used to transmit and receive data signals Attention is also drawn to document US-A-5 705 958, which describes an apparatus for correcting quadrature error in a quadrature modutator and/or in a demodulator for a signal having a plurality of phase states, or of amplitude and phase states. The correction apparatus comprises a processor which, when the apparatus is used to correct quadrature error in a demodulator, transforms the levels P and Q of the digital signals output by the demodulation stage into corrected levels P' and Q' that satisfy certain relationships. These corrected levels are then applied to a decision element optionally after their maximum levels have equalized.

Furthermore attention is drawn to document US-A-5 111 155, which discloses a process whereby distortion introduced in phase modulated RF signals by amplifiers and other signal processors is substantially reduced by modifying complex modulating signals I,Q in a way that compensates for the amplifier phase error ($\varphi_e$ as a function of amplifier power P. I, Q are combined to calculate the amplifier power level and scaled by a parameter, e.g., K1=-d$\varphi_e$ /dP, to provide factor B so that compensated signals I"=AQ+BI and Q"=AI-BQ, where A is a constant, can be determined. When an RF carrier modulated by I", Q" is passed through the distorting amplifier the amplifier induced distortion is cancelled. Substantial reduction in bit error probability is obtained.

Attention is also drawn to document US-A- 5 412 351, which discloses a compact local oscillator network for use in a quadrature modulator and/or demodulator. Single side band circuitry is configured to produce quadrature signals with a high degree of accuracy such that two equal amplitude signals are generated having a precise 90° phase difference. The network accuracy is substantially not affected by phase or amplitude imbalances within or introduced into the network. For example, the network may include: a first quadrature circuit for dividing a first input signal into a first inphase signal and a first quadrature signal 90° out of phase; a second quadrature circuit for dividing a second input signal into a second in-phase signal and a second quadrature signal 90° out of phase; a first mixer for mixing said first in-phase signal and said second in-phase signal; a second mixer for mixing said first quadrature signal and said second quadrature signal; a third mixer for mixing said first quadrature signal and said second in-phase signal; a fourth mixer for mixing said first in-phase signal and said second quadrature signal; a first combiner for combining the outputs of said first and second mixers into a first combiner for combining the outputs of said first and second mixers into a first local oscillator output signal; and a second combiner for combining the outputs of said third and fourth mixers into a second local oscillator output signal.

Finally, attention is drawn to document US-A-4 053 882, which discloses a polarization radar method and system that employs polarization discrimination to obtain target-to-clutter enhancement. The polarization of the radar is rotated at very fast rates. The polarization is rotated at least 360° during one pulse and discrimination is obtained with a single pulse operation. In the system, the receiver is tuned to a frequency that was not radiated by the radar's transmitting antenna.

SUMMARY OF THE INVENTION

In accordance with the present invention, a modulator, as set forth in claim 1, a method for modulating information, as set forth in claim 12, and a demodulator, as set forth in claim 15, are provided. Embodiments are described in the dependent claims.

The present invention provides modulator and demodulator architectures having improved performance over conventional architectures.

An embodiment of the invention provides a modulator that includes four mixers and two summers. The first mixer receives and modulates an inphase carrier signal with an inphase information signal to generate a first modulated component. The second mixer receives and modulates a quadrature carrier signal with a quadrature information signal to generate a second modulated component. The third mixer receives and modulates the inphase carrier signal with the quadrature information signal to generate a third modulated component that includes a signal inversion. The fourth mixer receives and modulates the quadrature carrier signal with the inphase information signal to generate a fourth modulated component. The first summer receives and combines the first and fourth modulated components to generate an inphase modulated component. The second summer receives and combines the second and third modulated components to generate a quadrature modulated component. Each of the inphase and quadrature carrier signals is provided as a differential signal.

A third summer can be used to receive and combine the inphase and quadrature modulated components to provide a modulated signal. The signal inversion can be achieved by inverting either the inphase carrier signal or the quadrature information signal provided to the third mixer. The mixers can be implemented using Gilbert cell multipliers.

Yet another embodiment of the invention provides a transmitter that includes a modulator. The modulator can be implemented using one of the embodiments described above.

Yet another embodiment of the invention provides a demodulator that includes first through fourth mixers and first and second summers. The first and third mixers receive and demodulate a modulated signal with an inphase carrier signal to provide first and third demodulated components, respectively. The second and fourth mixers receive and demodulate the modulated signal with a quadrature carrier signal to provide second and fourth demodulated components, respectively. The first summer receives and combines the first and fourth demodulated components to provide an inphase demodulated signal. The second summer receives and subtracts the third demodulated component from the second demodulated component to provide a quadrature demodulated signal.

Each of the inphase and quadrature carrier signals is provided as a differential signal.

**BRIEF DESCRIPTION OF THE DRAWINGS**

The features, nature, and advantages of the present invention will become more apparent from the detailed description set forth below when taken in conjunction with the drawings in which like reference characters identify correspondingly throughout and wherein:

FIG. 1 shows a simplified block diagram of an embodiment of a transmitter that performs quadrature modulation (e.g., QPSK and OQPSK) using two frequency conversion stages;
FIG. 2 shows a simplified block diagram of an embodiment of a transmitter that performs direct quadrature modulation using a single frequency conversion stage;
FIG. 3A shows a block diagram of an embodiment of a conventional quadrature modulator;
FIG. 3B shows a schematic diagram of an embodiment of a conventional quadrature modulator implemented with Gilbert cell mixers;
FIG. 4 shows a block diagram of an embodiment of a quadrature modulator of the invention;
FIG. 5 shows a block diagram of a specific implementation of the quadrature modulator of the invention;
FIG. 6A shows a schematic diagram of a specific embodiment of a Gilbert cell multiplier;
FIG. 6B shows a schematic diagram of a specific embodiment of a transconductance amplifier that receives an input voltage signal and generates an output current signal;
FIG. 7A shows a plot of image rejection versus gain error for a conventional modulator;
FIG. 7B shows a plot of image rejection versus gain error for the modulator shown in FIG. 4;
FIGS. 8 and 9 show block diagrams of two embodiments of a quadrature demodulator; and
FIG. 10 shows plots of the mixing functions $M_I(t)$ and $M_Q(t)$.

## DETAILED DESCRIPTION OF THE SPECIFIC EMBODIMENTS

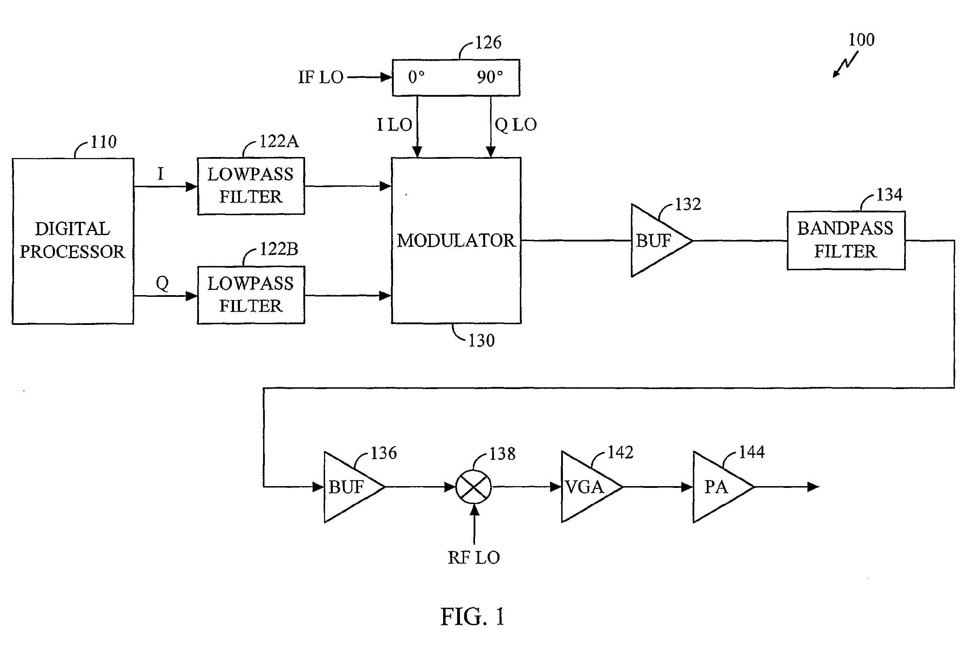

FIG. 1 shows a simplified block diagram of an embodiment of a transmitter 100 that performs quadrature modulation (e.g., QPSK and OQPSK) using two frequency conversion stages. A digital processor 110 generates data, encodes and modulates the data, and converts the digitally processed data into an inphase (I) signal and a quadrature (Q) signal. The baseband I and Q signals are provided to a pair of lowpass filters 122a and 122b, respectively, that perform (i.e., match) filtering of the baseband signals and provide the filtered I and Q signals to a modulator 130. Modulator 130 also receives an inphase carrier signal (I LO) and a quadrature carrier signal (Q LO) from a phase splitter 126 and modulates the carrier signals with the baseband signals to generate a modulated signal at an intermediate frequency (IF). The IF modulated signal from modulator 130 is provided to a buffer 132 that buffers the IF signal and drives a bandpass filter 134. Filter 134 filters the IF signal to remove out-of-band noise and undesired signals and images.

The filtered IF signal is provided to a buffer 136 that buffers the signal and drives a mixer 138. Mixer 138 also receives a carrier signal at a radio frequency (RF LO), and upconverts the buffered signal with the RF LO to generate a RF signal. The RF signal is provided to a variable gain amplifier (VGA) 142 that amplifies the signal with a gain determined by a gain control signal from a gain control circuit (not shown). The amplified RF signal is provided to a power amplifier (PA) 144 that provides the required signal drive. The output of PA 144 couples to an antenna via an isolator and a duplexer (all three elements not shown in FIG. 1).

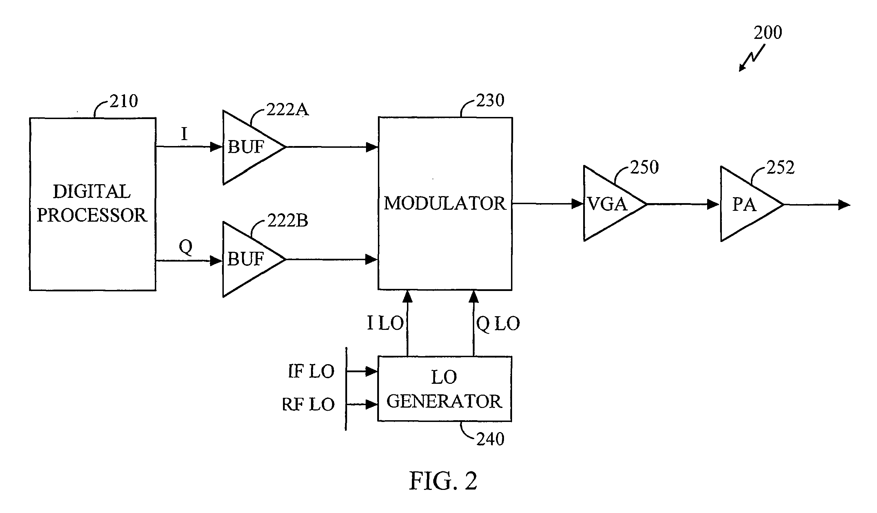

FIG. 2 shows a simplified block diagram of an embodiment of a transmitter 200 that performs direct quadrature modulation using a single frequency conversion stage. A digital processor 210 generates data, encodes and modulates the data, and converts the digitally processed data into an I signal and a Q signal, similar to processor 110 in FIG. 1. The baseband I and Q signals are provided to a pair of buffers 222a and 222b, respectively, that buffer the signals and provide the buffered baseband signals to a modulator 230. Modulator 230 also receives an inphase carrier signal (I LO) and a quadrature carrier signal (Q LO) from a LO generator 240 and modulates the carrier signals with the baseband signals to generate a RF modulated signal. In an embodiment, I LO and Q LO are generated from carrier signals at two frequencies (e.g., an IF LO and a RF LO). The RF modulated signal is provided to a VGA 250 that amplifies signal with a gain determined by a gain control signal (not shown). The amplified RF signal is provided to a PA 252 that drives an antenna.

Various modifications can be made to the transmitter embodiments shown in FIGS. 1 and 2. For example, the transmit signal path can be designed to include fewer or additional buffer and amplifier stages, fewer or additional filter stages, and other circuits. As an example, a filter can be provided after modulator 230 in FIG. 2 to filter out spurious signals. Moreover, the elements within the signal path can be arranged in different configurations. In a specific implementation, the transmit signal path from the digital processor to the PA is implemented within one or more integrated circuits, although discrete elements can also be used.

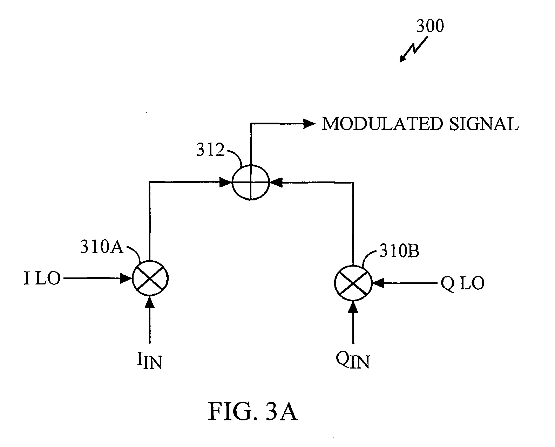

FIG. 3A shows a block diagram of an embodiment of a conventional quadrature modulator 300. Modulator 300 can be used as modulators 130 and 230 in FIGS. 1 and 2, respectively. Within modulator 300, the inphase information signal $I_{IN}$ is provided to a mixer 310a and the quadrature information signal $Q_{IN}$ is provided to a mixer 310b. The inphase and quadrature signals $I_{IN}$ and $Q_{IN}$ are processed versions of the I and Q signals, respectively. Mixers 310a and 310b also receive the carrier signals I LO and Q LO, respectively. Each mixer modulates the carrier signal with the information signal to generate a modulated component. The inphase and quadrature modulated components from mixers 310a and 310b, respectively, are provided to a summer 312 that combines the components to generate the modulated signal.

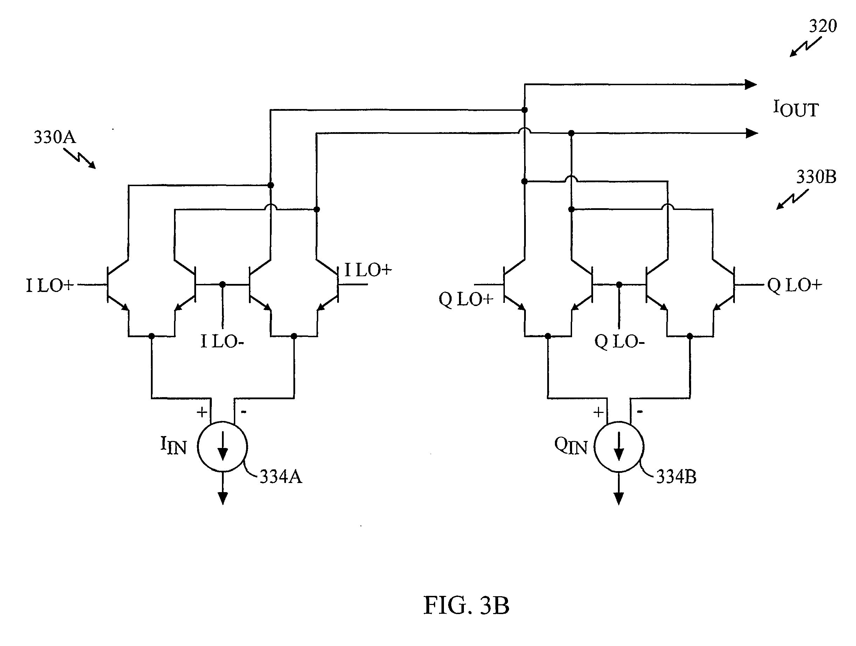

FIG. 3B shows a schematic diagram of an embodiment of a conventional quadrature modulator 320 implemented with Gilbert cell mixers. Modulator 320 is a specific implementation of modulator 300 in FIG. 3A. Mixers 310a and 310b are implemented with Gilbert cell mixers 330a and 330b, respectively, and summer 312 is implemented by cross-coupling the collector outputs of the Gilbert cell mixers. The currents representative of the inphase and quadrature signals $I_{IN}$ and $Q_{IN}$ are provided by respective current sources 334a and 334b that couple to mixers 330a and 330b, respectively. The differential output current $I_{OUT}$ from modulator 320 can be expressed as:

$$I_{OUT} = 2M_{I,G}(t) \bullet \Delta i + 2M_{Q,G}(t) \bullet \Delta q \ , \qquad \text{Eq. (1)}$$

where
$\Delta i$ is the differential current related to the inphase information signal $I_{IN}$

$$\{\Delta i = \alpha(I_{IN+} - I_{IN-})/2\};$$

$\Delta q$ is the differential current related to the quadrature information signal $Q_{IN}$

$$\{\Delta q = \alpha(Q_{IN+} - Q_{IN-})/2\};$$

$\alpha$ is a constant related to the transconductance gain of current sources 334; and $M_{I,G}(t)$ and $M_{Q,G}(t)$ are Gilbert cell mixing functions, which can be expressed as:

$$M_{I,G}(t) = \tanh\left(\frac{I \, LO}{2V_T}\right), \text{ and} \qquad \text{Eq. (2)}$$

$$M_{Q,G}(t) = \tanh\left(\frac{Q \, LO}{2V_T}\right). \qquad \text{Eq. (3)}$$

For I LO and Q LO much greater than $2V_T$, $M_{I,G}(t)$ and $M_{Q,G}(t)$ resemble square waves that are shifted by 90 degrees, with $M_{I,G}(t)$ leading $M_{Q,G}(t)$ by 90 degrees.

The simplified modulator architecture in FIG. 3A is susceptible to amplitude and phase errors in the carrier signals, which result in cross-talk between the I and Q modulated components. In modulator 300, any phase error (i.e., from the ideal 90°) in the two carrier signals is directly reflected as the phase error in the modulated components. For example, if the I and Q carrier signals are 90+y degrees out of phase, where y represents the phase error, the I and Q modulated components are also 90+y degrees out of phase and includes a phase error of y. In practical implementations, the carrier signals are limited (e.g., clipped) to reduce amplitude mismatch and variations. Modulator 300 is also susceptible to gain and phase errors in the mixers themselves, which degrade the modulated signal in similar manner as the amplitude and phase errors in the carrier signals. For example, a gain error of x percent (or a phase error of y degrees) in the mixer is equivalent to an amplitude error of x percent (or a phase error of y degrees) in the carrier signal, where x and y may not be linearly related. In modulator 300, the gain or amplitude error in the mixers similarly (and directly) affects the amplitude and phase of the modulated components.

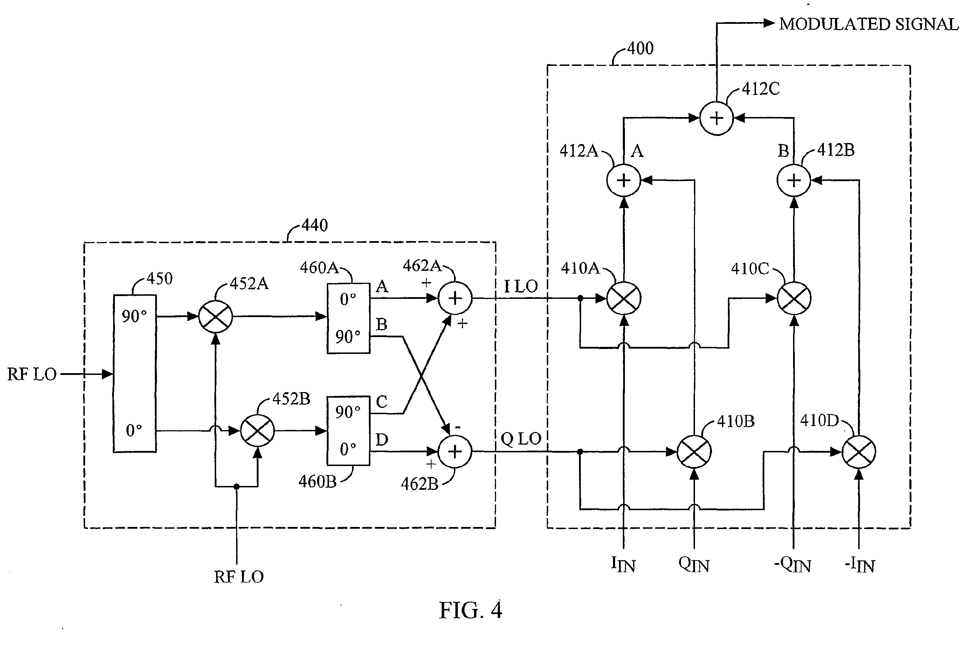

FIG. 4 shows a block diagram of an embodiment of a quadrature modulator 400. Modulator 400 can be used to implement modulators 130 and 230 in FIGS. 1 and 2, respectively. Within modulator 400, the inphase information signal $I_{IN}$ is provided to mixers 410a and 410d, the quadrature information signal $Q_{IN}$ is provided to a mixer 410b, and the inverted quadrature information signal -$Q_{IN}$ is provided to a mixer 410c. Each of mixers 410a and 410c also receives the inphase carrier signal I LO, and each of mixers 410b and 410d also receives the quadrature carrier signal Q LO.

Each mixer modulates the carrier signal with the information signal to generate a modulated component. Specifically, mixer 410a modulates the I LO with the inphase signal $I_{IN}$ to generate a first modulated component, mixer 410b modulates the Q LO with the quadrature signal $Q_{IN}$ to generate a second modulated component, mixer 410c modulates the I LO with the inverted quadrature signal $-Q_{IN}$ to generate a third modulated component, and mixer 410d modulates the Q LO with the inphase signal $I_{IN}$ to generate a fourth modulated component. The first and second modulated components are combined by a summer 412a to generate the modulated output for the first (or left) modulation unit, and the third and fourth modulated components are combined by a summer 412b to generate the modulated output for the second (or right) modulation unit. The outputs from both modulation units are combined by a summer 412c to generate the modulated signal.

Modulator 400 can be viewed as including two modulation units and a summer. One modulation unit comprises mixers 410a and 410b and summer 412a, and the other modulation unit comprises mixers 410c and 410d and summer 412b. Each modulation unit receives a set of information signals (e.g., $I_{IN}$ and $Q_{IN}$) and a set of carrier signals (e.g., I LO and Q LO), and modulates the carrier signals with the information signals in accordance with a particular modulation scheme (e.g., QPSK). The information signals to the mixers within the second modulation unit are swapped and the Q signal or the I LO is also inverted, relative the signals to the mixers within the first modulation unit. Thus, each modulation unit generates a different modulated component.

In the specific modulator embodiment shown in FIG. 4, the second modulation unit receives the information signals $I_{IN}$ and $-Q_{IN}$ that are used to modulate the Q LO and I LO, respectively. This differs from the first modulation unit, which receives the information signals $I_{IN}$ and $Q_{IN}$ that are used to modulate the I LO and Q LO, respectively. The modulated components from the first and second modulation units are provided to, and combined by summer 412c to generate the modulated signal.

Various modifications can be made to the specific embodiment shown in FIG. 4. For example, the I LO to mixer 410c can be inverted instead of the quadrature signal $Q_{IN}$. Moreover, the second modulation unit can be designed to receive non-inverted information and carrier signals, and to internally perform the signal inversion. For example, the second modulation unit can internally invert either the quadrature signal $Q_{IN}$ or the I LO before mixer 410c, or alternatively can invert the output of mixer 410c. In implementations of the modulator using differential signals, inversion of either the carrier signal, the information signal, or the mixer output can be readily achieved by simply swapping the differential signal lines.

The specific embodiment of modulator 400 shown in FIG. 4 can performs quadrature modulation (e.g., QPSK or OQPSK, depending on the timing alignment of the information signals $I_{IN}$ and $Q_{IN}$). The invention can be extended to other modulation schemes (e.g., BPSK, PSK, and so on). Generally, two modulation units are provided. One unit modulates the carrier signals with the information signals in accordance with a particular modulation scheme. The other unit receives the information and carrier signals, performs the proper signal swapping and inversion as necessary, and modulates the carrier signals with the information signals in accordance with the particular modulation scheme. The modulated components from the two modulation units are then combined to generate the modulated signal.

FIG. 4 also shows a block diagram of a specific embodiment of a LO generator 440 that can be used in conjunction with the modulator of the invention. LO generator 440 can be used as LO generator 240 in FIG. 2. Within LO generator 440, an IF carrier signal (IF LO) is provided to a phase shift network 450 that provides two output carrier signals that are in quadrature, i.e., one carrier signal having an additional 90 degrees of phase shift relative to the other carrier signal. The inphase and quadrature outputs from phase shifting circuit 450 are provided to mixers 452b and 452a, respectively. Each mixer 452 also receives the RF carrier signal (RF LO) and mixes the two received carrier signals. The output from mixers 452a and 452b are provided to phase shift networks 460a and 460b, respectively. Each phase shift network 460 generates an inphase component and a quadrature component of the input signal. The outputs from phase shift networks 460a and 460b are cross-coupled and provided to summers 462a and 462b. Summer 462a receives and adds the inphase component from phase shift network 460a and the quadrature component from phase shift network 460b to generate the inphase carrier signal I LO. Summer 462b receives and subtracts the quadrature component from phase shift network 460a from the inphase component from phase shift network 460b to generate the quadrature carrier signal Q LO.

If the RL LO is expressed as $\sin(\omega_{RF})$ and the IF LO is expressed as $\cos(\omega_{IF})$, the I LO and Q LO can be expressed as:

$$I\ LO = \cos(\omega_{RF} - \omega_{IF})\ , \text{and} \qquad\qquad \text{Eq. (4)}$$

$$Q\ LO = \sin(\omega_{RF} - \omega_{IF})\ . \qquad\qquad \text{Eq. (5)}$$

Other LO generators can also be used with the modulator and demodulator of the invention. For example, the invention can be used in combination with the LO generator described in U.S. Patent No. 5,412,351, entitled "Quadrature Local Oscillator Network."

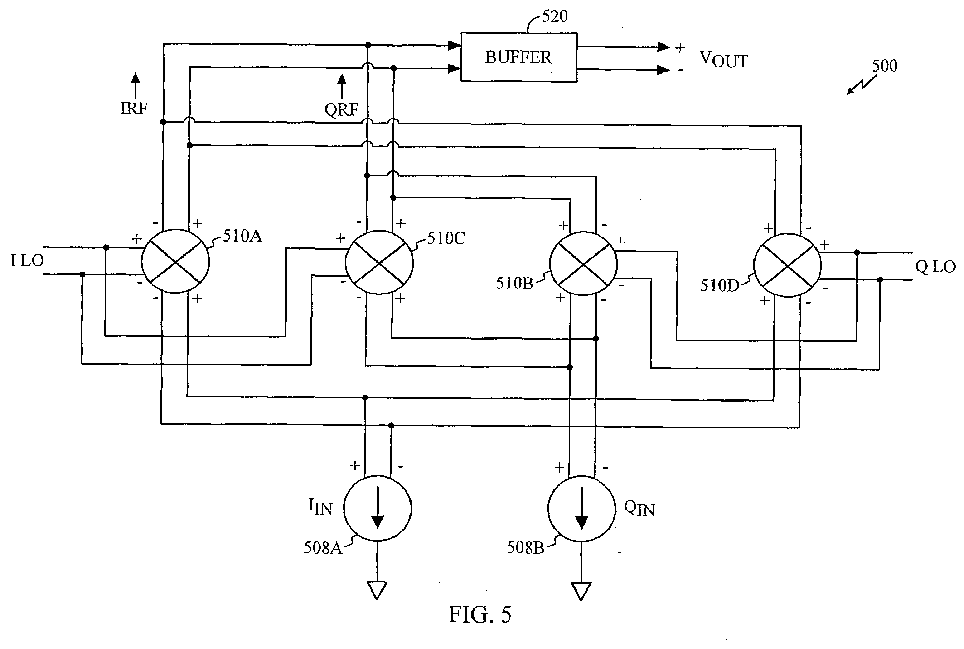

FIG. 5 shows a block diagram of an embodiment of a quadrature modulator 500 of the invention. Modulator 500 is one implementation of modulator 400 in FIG. 4. Mixers 510a through 510d in FIG. 5 correspond to mixers 410a through 410d in FIG. 4.

Within modulator 500, the inphase information signal $I_{IN}$ is represented by a current source 508a that provides a current proportional to the inphase signal $I_{IN}$. This current source can be a part of a transconductance circuit that receives an input voltage signal and generate an output current signal. Similarly, the quadrature information signal $Q_{IN}$ is represented by a current source 508b that provides a current proportional to the quadrature signal $Q_{IN}$. As shown in FIG. 5, each current source 508 provides a differential output (current) signal.

The differential inphase carrier signal I LO is provided to the inputs of mixers 510a and 510c, and the differential quadrature carrier signal Q LO is provided to the inputs of mixers 510b and 510d. Mixers 510a and 510d also couple to current source 508a, and mixers 510b and 510c also couple to current source 508b. It should be noted that the differential signal lines between mixer 510c and current source 508b are swapped to provide a signal inversion. Specifically, the current signal related to $I_{IN}$ is provided to mixers 510a and 510d without an inversion, and the current signal related to $Q_{IN}$ is provided to mixer 510b without an inversion and to mixer 510c with an inversion.

Each mixer 510 mixes the information and carrier signals to generate a differential output current signal. For mixers 510 having current outputs, the summing functions can be implemented by coupling together the appropriate signal lines. Thus, the outputs from mixers 510a and 510d can be conveniently coupled together to form the inphase modulated component $I_{RF}$, and the outputs from mixers 510b and 510c can be conveniently coupled together to form the quadrature modulated component $Q_{RF}$. For some modulator implementations, the modulated components $I_{RF}$ and $Q_{RF}$ are provided as the modulator output signals. For some other modulator implementations, the inphase and quadrature modulated components are combined to form a modulated signal $I_{MOD}$ from the modulator. A buffer 520 receives and buffers the current signal, and can also be designed to convert the differential current signal to a differential voltage signal $V_{OUT}$.

The modulated signal from modulator 500, for mixers implemented with bipolar transistors, can be expressed as:

$$I_{MOD} = I_{RF} + Q_{RF} \ , \qquad\qquad\qquad \text{Eq. (6)}$$

$$I_{RF} = 2\Delta i \bullet M_I(t) + 2\Delta q \bullet M_Q(t) \ , \qquad\qquad\qquad \text{Eq. (7)}$$

$$Q_{RF} = 2\Delta i \bullet M_Q(t) - 2\Delta q \bullet M_I(t) \ , \qquad\qquad\qquad \text{Eq. (8)}$$

where
$I_{MOD}$ is the output current representative of the modulated signal;
$I_{RF}$ is the I modulated component;
$Q_{RF}$ is the Q modulated component;
$\Delta i$ is the differential current related to the inphase information signal $I_{IN}$

$$\{\Delta i = \alpha(I_{IN+} - I_{IN-})/2\};$$

$\Delta q$ is the differential current related to the quadrature information signal $Q_{IN}$

$$\{\Delta q = \alpha(Q_{IN+} - Q_{IN-})/2\};$$

$\alpha$ is a constant related to the transconductance gain of current sources 508;
$M_I(t)$ is the I channel mixing function; and

$M_Q(t)$ is the Q channel mixing function.

With current source 508a coupled to mixers 510a and 510d and current source 508b coupled to mixers 510b and 510c, $M_I(t)$ and $M_Q(t)$ can be expressed as:

$$M_I(t) = \frac{\sinh\left(\dfrac{I\ LO}{2V_T}\right)}{\cosh\left(\dfrac{I\ LO}{2V_T}\right) + \cosh\left(\dfrac{Q\ LO}{2V_T}\right)}, \text{ and} \qquad \text{Eq. (9)}$$

$$M_Q(t) = \frac{\sinh\left(\dfrac{Q\ LO}{2V_T}\right)}{\cosh\left(\dfrac{I\ LO}{2V_T}\right) + \cosh\left(\dfrac{Q\ LO}{2V_T}\right)}. \qquad \text{Eq. (10)}$$

$I_{MOD}$ can then be expressed as:

$$I_{MOD} = \frac{2\Delta i\left[\sinh\left(\dfrac{I\ LO}{2V_T}\right) + \sinh\left(\dfrac{Q\ LO}{2V_T}\right)\right] + 2\Delta q\left[\sinh\left(\dfrac{Q\ LO}{2V_T}\right) - \sinh\left(\dfrac{I\ LO}{2V_T}\right)\right]}{\cosh\left(\dfrac{I\ LO}{2V_T}\right) + \cosh\left(\dfrac{Q\ LO}{2V_T}\right)}, \text{Eq. (11)}$$

Equation (11) includes four "sinh" terms, with the first through fourth sinh terms generated by mixers 510a, 510d, 510b, and 510c, respectively.

Modulator 500 includes two modulation units. One modulation unit includes mixers 510a and 510b, and the other modulation unit includes mixers 510c and 510d. Current sources 508a and 508b provide currents representative of the information signals. Each current source 508 couples to one mixer in each of the two modulation units. The two modulation units provide two single sideband (SSB) outputs (i.e., two modulated components) that are in quadrature. Each of the SSB outputs has improved image rejection performance that is provided, in part, by the mixing functions $M_I(t)$ and $M_Q(t)$ shown in equations (9) and (10). The SSB outputs can be summed together to provide the modulated signal.

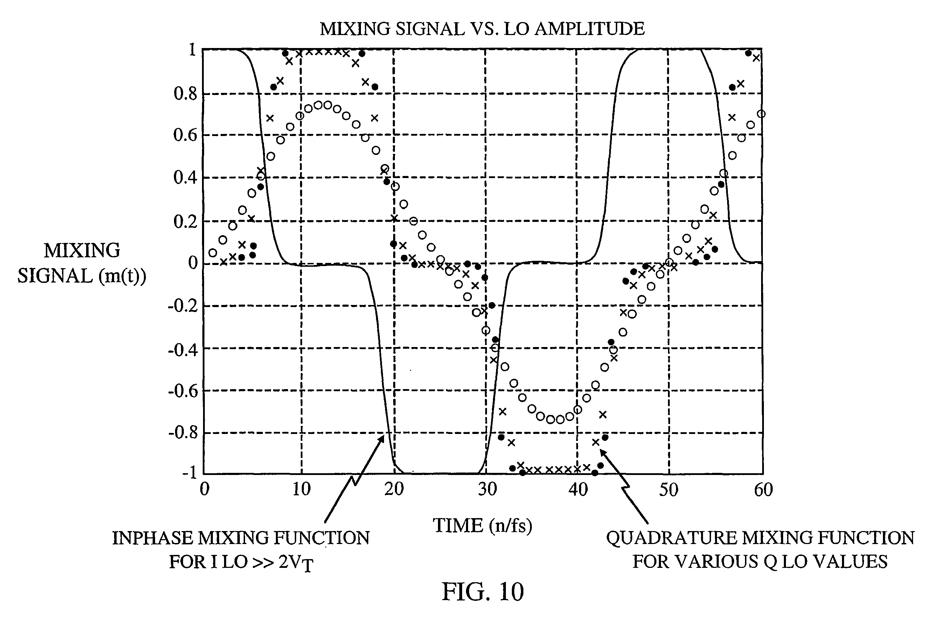

FIG. 10 shows plots of the mixing functions $M_I(t)$ and $M_Q(t)$. It can be noted that the mixing function has three approximately signal levels when the amplitude of the carrier signal is much greater than $2V_T$ (i.e., ILO and Q LO >> $2V_T$). As the signal level decreases, the mixing function resembles a sinusoid.

Modulator 500 operates in the following manner. Each information signal $I_{IN}$ or $Q_{IN}$ controls a respective current source. The current through each current source varies depending on the value of the respective information signal. The current through each current source is effectively steered from the mixer in one modulation unit to the mixer in the other modulation unit as the carrier signal changes phase, resulting in the mixers being alternatively turned on and off (i.e., every 90 degrees). This results in a mixing function that has three signal levels, instead of two signal levels for conventional mixers. The current steering reduces the modulator's sensitivity to the switching edges of the carrier signals.

In the implementation shown in FIG. 5, the carrier signals are provided to the inputs of the mixers. The carrier signals control the switching of the mixers and should be of sufficient amplitude to effectively switch the mixers. In fact, a reduction in sensitivity to phase error, up to a limit, may be obtained by sharpening the switching edges of the carrier signals.

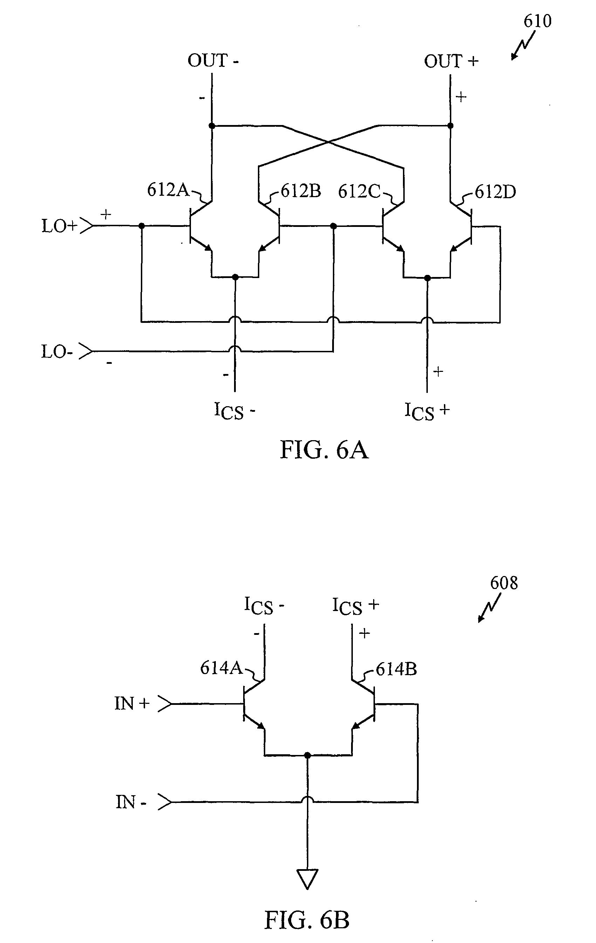

FIG. 6A shows a schematic diagram of a specific embodiment of a Gilbert cell multiplier (or mixer) 610. Mixer 610 is a specific implementation of mixer 510 in FIG. 5 and includes a pair of cross-coupled differential amplifier. The first differential amplifier comprises transistors 612a and 612b having their bases coupled to the carrier signals LO+ and LO-, respectively, and their emitters coupled together. Similarly, the second differential amplifier comprises transistors 612c and 612d having their bases coupled to the carrier signals LO- and LO+, respectively, and their emitters also coupled together. The differential carrier signal LO+ and LO- corresponds to either the inphase carrier signal I LO or the quadrature carrier signal Q LO in FIG. 5.

The emitters of transistors 612a and 612b couple to a current source that provides the current signal Ics-, and the emitters of transistors 612c and 612d couple to a current source that provides the current signal Ics+. The collectors of transistors 612a and 612c couple together and form the mixer output OUT-, and the collectors of transistors 612b and 612d couple together and form the mixer output OUT+. Each of the six inputs and outputs of mixer 610 is appropriately marked as either a (+) or (-) terminal, corresponding to the (+) and (-) designations shown in FIG. 5. Mixer 610 functions similar to a Gilbert cell multiplier known in the art.

FIG. 6B shows a schematic diagram of a specific embodiment of a transconductance amplifier 608 that receives an input voltage signal and generates an output current signal. Amplifier 608 is a specific implementation of current source 508 in FIG. 5. Amplifier 608 includes transistors 614a and 614b configured as a differential amplifier and having their emitters coupled together and to circuit ground. The bases of transistors 614a and 614b couple to the information signals IN+ and IN-, respectively. The signal IN can be the inphase or quadrature information signal $I_{IN}$ or $Q_{IN}$ in FIG. 5. The collectors of transistors 614a and 614b provide the output current signals Ics- and Ics+, respectively. The differential current signal is provided to the mixers. In FIG. 5, it should be noted that the interconnections between mixer 510c and current source 508b are swapped to generate an inverted quadrature information signal $-Q_{IN}$.

Mixer 610 and transconductance amplifier 608 represent one implementation of mixer 510 and current source 508. Other implementations can also be designed and are within the scope of the invention. Transconductance amplifier 608 typically has a transfer function that is non-linear. In some implementations, a digital-to-analog converter (DAC) can be used to provide linear current. One DAC would be provided for each of current sources 508a and 508b, and would couple directly to the associated mixers 510. The mixers can also be implemented as single balance or double balance diode mixers, as is known in the art. In general, the mixers can be implemented using non-linear devices. For improved performance, the mixing functions are typically matched to the particular mixer implementation.

The modulator architecture of the invention provides improved performance and many advantages over conventional modulator architectures. The improvements include less sensitivity to amplitude and phase errors in the carrier signals, and less sensitivity to gain and phase errors in the mixers. Some of these advantages are described below.

First, the modulator architecture of the invention is more tolerant to amplitude and phase errors than conventional modulator architectures.

Second, the modulators of the invention provide improved image rejection for single side band (SSB) modulation, through the use of a modified mixing function. In some applications, SSB modulation is preferred or required. Typically, the information signals used to modulate the carrier signals include spectral components in positive as well as negative frequencies. When carrier signals are modulated with these information signals (i.e., using modulator 300 in FIG. 3A), an image appear at the sum and difference frequencies, resulting in a double side band (DSB) modulated signal. The modulator of the invention provides two SSB modulated components (i.e., one from each modulation unit). Each of the I and Q modulated components has good image rejection.

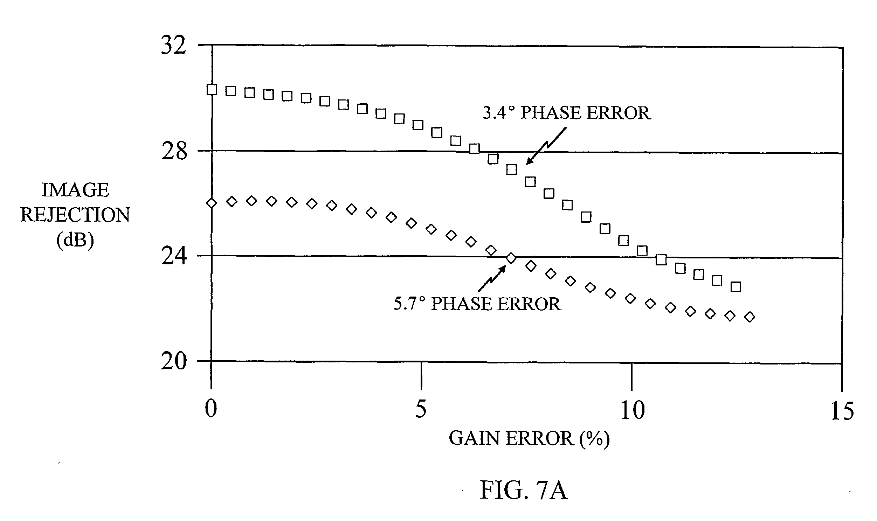

FIG. 7A shows a plot of image rejection versus gain error for a conventional modulator. This conventional modulator includes a pair of mixers, similar to modulator 300 in FIG. 3A. The conventional modulator provides approximately 26 dB of image rejection with 5.7 degrees of phase error and no gain errors. The image rejection improves to approximately 30 dB with 3.4 degrees of phase error and no gain errors. At a gain error of 6 percent, the image rejection is approximately 25 dB and 28 dB for phase errors of 5.7 degrees and 3.4 degrees, respectively.

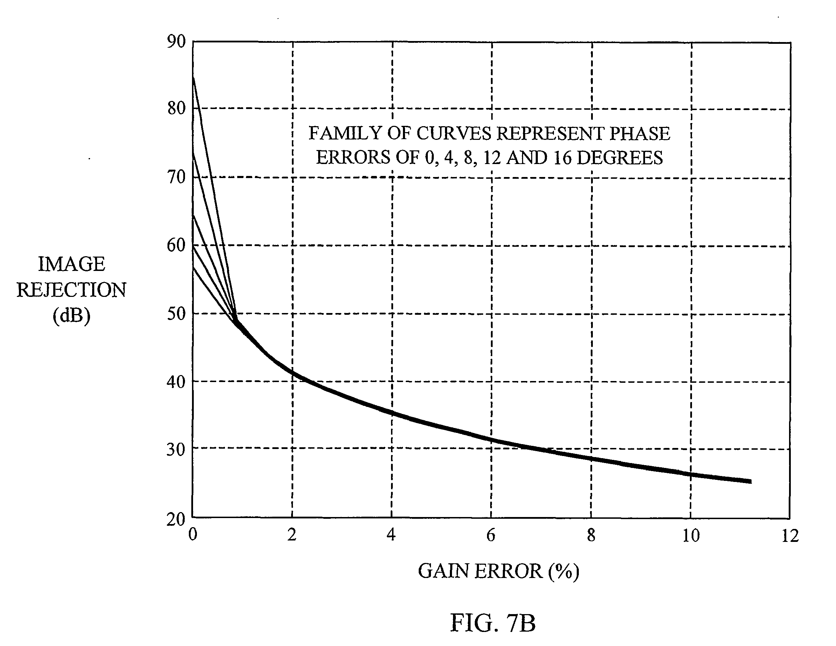

FIG. 7B shows a plot of image rejection versus gain error for modulator 400. Modulator 400 provides over 50 dB of image rejection with zero to 16 degrees of phase error and no gain errors. At a gain error of 6 percent, the image rejection is approximately 30 dB for phase errors of between zero to 16 degrees.

Third, the modulator architecture of the invention provides reduced cross-talk between the demodulated I and Q signals. For quadrature modulation, the inphase and quadrature information signals are used to generate the inphase and quadrature modulated components, respectively, that are combined to form the modulated signal. At the receiver, the modulated signal is demodulated using an inphase carrier signal and a quadrature carrier signal (generated at the receiver) to decompose the modulated signal into the inphase and quadrature signals (corresponding to the inphase and quadrature information signals, respectively). For an ideal modulated signal that is demodulated with an ideal demodulator, the demodulated inphase signal does not include any quadrature component, and the demodulated quadrature signal does not include any inphase component. However, it can be shown that any amplitude and/or phase error in the modulated signal results in I-Q crosstalk at the receiver, or a demodulated inphase signal containing some amounts of quadrature component, and vice versa. The modulator architecture of the invention effectively reduces the degradation in the modulated signal due to amplitude and phase errors, which then results in less crosstalk at the receiver.

For clarity, the invention has been described in the context of a quadrature modulator within a transmitter. The invention can also be applied to other types of modulators, such as PSK and QAM modulators, and others. The invention can also be embodied in a demodulator that receives a RF modulated signal and demodulates the signal to generate demodulated signals.

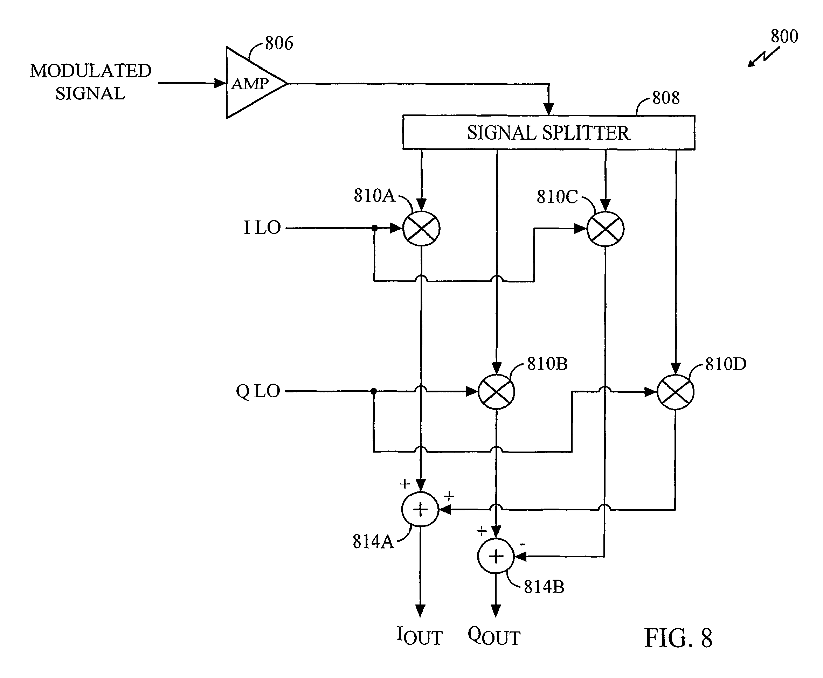

FIG. 8 shows a block diagram of an embodiment of a quadrature demodulator 800. Within demodulator 800, the modulated signal is provided to an amplifier 806 that buffers and amplifies the signal. The amplified signal is provided to a signal splitter 808 that provides four output signals having approximately equal amplitude and phase. The four signals are provided to mixers 810a through 810d. Each of mixers 810a and 810c also receives an inphase carrier signal I LO, and each of mixers 810b and 810d also receives a quadrature carrier signal Q LO. Each mixer demodulates the modulated signal with the carrier signal to provide a demodulated component. The demodulated components from mixers 810a and 810d are combined by a summer 814a to generate the inphase demodulated output $I_{OUT}$. The demodulated component from mixer 810c is subtracted from the demodulated component from mixer 810b by a summer 814b to generate the quadrature demodulated output $Q_{OUT}$. The demodulated outputs $I_{OUT}$ and $Q_{OUT}$ correspond to the inphase and quadrature signals $I_{IN}$ and $Q_{IN}$ at the transmitter.

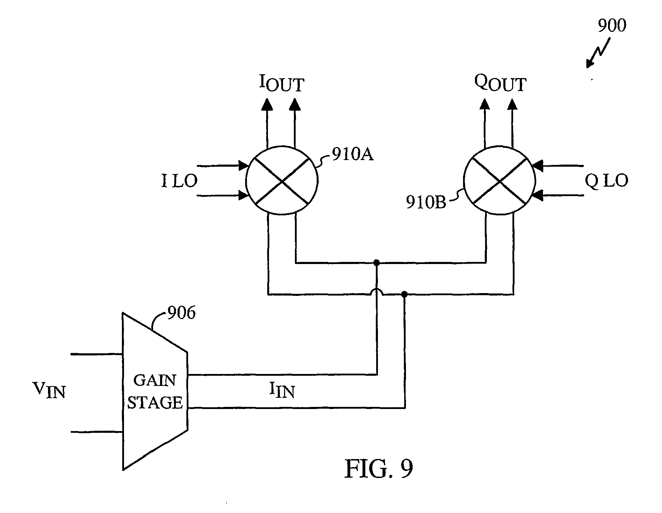

FIG. 9 shows a block diagram of another embodiment of a quadrature demodulator 900. Within demodulator 900, the modulated signal is provided to a gain stage 906 that provides a differential output current $I_{in}$. Gain stage 906 can be implemented as a transconductance amplifier, a current source, or other circuits having an output impedance much greater than the input impedance of a Gilbert cell mixer. The output of gain stage 906 couples to one input of each of mixers 910a and 910b. Mixer 910a also receives the inphase carrier signal I LO and mixer 910b also receives the quadrature carrier signal Q LO. The inphase $I_{OUT}$ and quadrature $Q_{OUT}$ demodulated components can be expressed as:

$$I_{OUT} = M_I(t) \bullet I_{in} \text{ , and} \qquad\qquad \text{Eq. (12)}$$

$$Q_{OUT} = M_Q(t) \bullet I_{in} \text{ ,} \qquad\qquad \text{Eq. (13)}$$

where $M_I(t)$ and $M_Q(t)$ are the mixing functions defined above in equations (9) and (10).

The invention has been described for a modulator and a demodulator. The invention can also be embodied in an upconverter that upconverts a signal from one frequency to another frequency. The invention can also be embodied in a downconverter that downconverts a RF signal from a higher frequency to a lower frequency. The downconverter can be implemented similar to a demodulator.

As used herein, a carrier signal refers to a signal that is modulated by an information bearing signal. The carrier signal can be implemented using various waveforms, including sine wave, square wave, triangular wave, and others. The carrier signal can include multiple frequency components (e.g., such as for the square wave), with one of the frequency components being designated as the fundamental frequency component where a major portion of the modulated signal resides.

The modulator can be implemented with a "stacked" circuit topology or a "cascaded" circuit topology. The stacked circuit topology (i.e., modulator 500 in FIG. 5) can consume less power, which is particularly advantageous, for example, in cellular telephone application. The cascaded topology may be used, for example, in applications having low supply voltages.

The modulator has been described with circuitry (e.g., Gilbert cell mixers) implemented using bipolar junction transistors (BJTs). The invention can also be implemented with other active devices including FETs, MOSFETs, MESFETs, HBTs, P-HEMTs, and others. As used herein, "transistor" generically refers to any active device, and is not limited to a BJT.

The foregoing description of the preferred embodiments is provided to enable any person skilled in the art to make or use the present invention. Various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features disclosed herein.

**Claims**

**1.** A modulator (500) comprising:

a first mixer (510A) configured to receive and modulate an inphase carrier signal (ILO) with an inphase information signal ($I_{IN}$) to generate a first modulated component;
a second mixer (510B) configured to receive and modulate a quadrature carrier signal (QLO) with a quadrature

information signal ($Q_{in}$) to generate a second modulated component;

a third mixer (510C) configured to receive and modulate the inphase carrier signal with the quadrature information signal ($Q_{in}$) to generate a third modulated component, wherein the third modulated components includes a signal inversion;

a fourth mixer (510D) configured to receive and modulate the quadrature carrier signal with the inphase information signal to generate a fourth modulated component;

a first summer coupled to the first and fourth mixers (510A, 510D), the first summer configured to receive and combine the first and fourth modulated components to generate an inphase modulated component; and

a second summer coupled to the second and third mixers (510B, 510C), the second summer configured to receive and combine the second and third modulated components to generate a quadrature modulated component wherein;

each of the inphase and quadrature carrier signals (ILO, QLO) is provided as a differential signal.

2. The modulator (500) of claim 1, wherein the inphase and quadrature carrier signals are approximately 90 degrees out of phase with respect to each other.

3. The modulator (500) of claim 1, wherein the mixers are implemented with Gilbert cell multipliers.

4. The modulator (500) of claim 3, wherein the Gilbert cell multipliers are implemented with bipolar transistors.

5. The modulator (500) of claim 3, wherein the Gilbert cell multipliers are implemented with MOSFETs.

6. The modulator (500) of claim 3, wherein the summers are implemented by cross-coupling outputs of the Gilbert cell multipliers.

7. The modulator (500) of claim 1, wherein the inphase and quadrature carrier signals are generated using two intermediate carrier signals.

8. The modulator (500) of claim 7, wherein the two intermediate carrier signals are at two different frequencies.

9. The modulator (500) of claim 7, wherein the two intermediate carrier signals include an IF carrier signal and a RF carrier signal.

10. The modulator (500) of claim 1, wherein the mixers and summers are implemented using a stacked circuit topology.

11. A transmitter (200) comprising the modulator of claim 1.

12. A method for modulating an information signal having an inphase component and a quadrature component, the method comprising:

modulating an inphase carrier signal (ILO) with the inphase component to generate a first modulated component;

modulating a quadrature carrier signal (QLO) with the quadrature component to generate a second modulated component;

modulating the inphase carrier signal (ILO) with the quadrature component to generate a third modulated component, wherein the third modulated component includes a signal inversion;

modulating the quadrature carrier signal (QLO) with the inphase component to generate a fourth modulated component;

summing the first and fourth modulated components to provide an inphase modulated component; and

summing the second and third modulated components to provide a quadrature modulated component wherein;

each of the inphase and quadrature carrier signals (ILO, QLO) is provided as a differential signal.

13. The method of claim 12, further comprising:

summing the inphase and quadrature modulated components to provide a modulated signal.

14. The method of claim 12, further comprising:

inverting either the inphase carrier signal (ILO) or the quadrature component before the modulating to generate the third modulated component.

**15.** A demodulator (900) comprising:

a first mixer configured to receive and demodulate a modulated signal with an inphase carrier signal (ILO) to provide a first demodulated component;

a second mixer configured to receive and demodulate the modulated signal with a quadrature carrier signaL (QLO) to provide a second demodulated component;

a third mixer configured to receive and demodulate the modulated signal with the inphase carrier signal (ILO) to provide a third demodulated component;

a fourth mixer configured to receive and demodulate the modulated signal with an quadrature carrier signal (QLO) to provide a fourth demodulated component;

a first summer coupled to the first and fourth mixers, the first summer configured to receive and combine the first and fourth demodulated components to provide an inphase demodulated signal ($I_{OUT}$) and

a second summer coupled to the second and third mixers, the second summer configured to receive and subtract the third demodulated component from the second demodulated component to provide a quadrature demodulated signal ($Q_{OUT}$) each of the inphase and quadrature carrier signals (ILO, QLO) is provided as a differential signal.

**Patentansprüche**

**1.** Ein Modulator (500), der Folgendes aufweist:

ein erstes Mischelement bzw. einen Mischer (510A), konfiguriert zum Empfangen und Modulieren eines Inphasen-Trägersignals (ILO) mit einem Inphasen-Informationssignal ($I_{IN}$) um eine erste modulierte Komponente zu generieren;

ein zweiter Mischer (510B), konfiguriert zum Empfangen und Modulieren eines Quadratur-Trägersignals (QLO) mit einem Quadratur-Informationssignal ($Q_{IN}$) um eine zweite modulierte Komponente zu generieren;

ein dritter Mischer (510C), konfiguriert zum Empfangen und Modulieren des Inphasen-Trägersignals mit dem Quadratur-Informationssignal ($Q_{IN}$) um eine dritte modulierte Komponente zu generieren, wobei die dritten modulierten Komponenten eine Signalumkehrung beinhalten;

ein vierter Mischer (510D), konfiguriert zum Empfangen und Modulieren des Quadratur-Trägersignals mit dem Inphasen-Informationssignal um eine vierte modulierte Komponente zu generieren;

ein erster Summierer, gekoppelt an die ersten und vierten Mischer (510A, 510D), wobei der erste Summierer konfiguriert ist um die ersten und vierten modulierten Komponenten zu empfangen und zu kombinieren, um eine modulierte Inphasen-Komponente zu generieren; und

ein zweiter Summierer, gekoppelt an die zweiten und dritten Mischer (510B, 510C), wobei der zweite Summierer konfiguriert ist zum Empfangen und zum Kombinieren der zweiten und dritten modulierten Komponenten, um eine modulierte Quadratur-Komponente zu generieren, wobei; ein jedes der Inphasen- und Quadratur-Trägersignale (ILO, QLO) als ein differentielles bzw. Differential-Signal vorgesehen wird.

**2.** Modulator (500) nach Anspruch 1, wobei die Inphasen- und Quadratur-Trägersignale bezüglich zueinander ungefähr 90 Grad aus der Phase verschoben sind.

**3.** Modulator (500) nach Anspruch 1, wobei die Mischer als Gilbert-Zellmultiplizierer implementiert sind.

**4.** Modulator (500) nach Anspruch 3, wobei die Gilbert-Zellmultiplizierer mit Bipolar-Transistoren implementiert sind.

**5.** Modulator (500) nach Anspruch 3, wobei die Gilber-Zellmultiplizierer mit MOSFETs implementiert sind.

**6.** Modulator (500) nach Anspruch 3, wobei die Summierer implementiert sind durch Kreuzkopplung von Ausgängen der Gilbert-Zellmultiplizierer.

**7.** Modulator (500) nach Anspruch 1, wobei die Inphasen- und Quadratur-Trägersignale generiert werden unter Verwendung von zwei Zwischenträgersignalen.

**8.** Modulator (500) nach Anspruch 7, wobei die zwei Zwischenträgersignale auf zwei unterschiedlichen Frequenzen sind.

9. Modulator (500) nach Anspruch 7, wobei die zwei Zwischenträgersignale ein ZF-Trägersignal und ein HF-Trägersignal beinhalten.

10. Modulator (500) nach Anspruch 1, wobei die Mischer und Summierer implementiert sind unter Verwendung einer aufeinander geschichteten bzw. gestapelten Schaltungstopologie.

11. Ein Sender (200), der den Modulator nach Anspruch 1 aufweist.

12. Ein Verfahren zum Modulieren eines Informationssignals mit einer Inphasen-Komponente und einer Quadratur-Komponente, wobei das Verfahren Folgendes aufweist:

Modulieren eines Inphasen-Trägersignals (ILO) mit der Inphasen-Komponente, um eine erste modulierte Komponente zu generieren;
Modulieren eines Quadratur-Trägersignals (QLO) mit der Quadratur-Komponente, um eine zweite modulierte Komponente zu generieren;
Modulieren des Inphasen-Trägersignals (ILO) mit der Quadratur-Komponente, um eine dritte modulierte Komponente zu generieren, wobei die dritte modulierte Komponente eine Signalumkehrung beinhaltet;
Modulieren des Quadratur-Trägersignals (QLO) mit der Inphasen-Komponente, um eine vierte modulierte Komponente zu generieren;
Summieren der ersten und vierten modulierten Komponenten, um eine modulierte Inphasen-Komponente vorzusehen; und
Summieren der zweiten und dritten modulierten Komponenten, um eine modulierte Quadratur-Komponente vorzusehen, wobei:

ein jedes der Inphasen- und Quadratur-Trägersignale (ILO, QLO) als ein Differentialsignal vorgesehen wird.

13. Verfahren nach Anspruch 12, das weiterhin Folgendes aufweist:

Summieren der modulierten Inphasen- und Quadratur-Komponenten um ein moduliertes Signal vorzusehen.

14. Verfahren nach Anspruch 12, das weiterhin Folgendes aufweist:

Invertieren entweder des Inphasen-Trägersignals (ILO) oder der Quadratur-Komponente vor dem Modulieren um die dritte modulierte Komponente zu generieren.

15. Ein Demodulator (900), der Folgendes aufweist:

einen ersten Mischer, der konfiguriert ist zum Empfangen und Demodulieren eines modulierten Signals mit einem Inphasen-Trägersignal (ILO) um eine erste demodulierte Komponente vorzusehen;
einen zweiten Mischer, der konfiguriert ist zum Empfangen und Demodulieren des modulierten Signals mit einem Quadratur-Trägersignal (QLO) um eine zweite demodulierte Komponente vorzusehen;
einen dritten Mischer, der konfiguriert ist zum Empfangen und Demodulieren des modulierten Signals mit dem Inphasen-Trägersignal (ILO), um eine dritte demodulierte Komponente vorzusehen;
einen vierten Mischer, der konfiguriert ist zum Empfangen und Demodulieren des modulierten Signals mit einem Quadratur-Trägersignal (QLO), um eine vierte demodulierte Komponente vorzusehen;
einen ersten Summierer, gekoppelt an den ersten und vierten Mischer, wobei der erste Summierer konfiguriert ist zum Empfangen und Kombinieren der ersten und vierten demodulierten Komponenten, um ein demoduliertes Inphasen-Signal (IOUT) vorzusehen; und
einen zweiten Summierer, gekoppelt an den zweiten und dritten Mischer, wobei der zweite Summierer konfiguriert ist zum Empfangen und Subtrahieren der dritten demodulierten Komponente von der zweiten demodulierten Komponente, um ein demoduliertes Quadratur-Signal (QOUT) vorzusehen, wobei ein jedes der Inphasen- und Quadratur-Trägersignale
(ILO, QLO) als ein Differentialsignal vorgesehen wird.

**Revendications**

1. Modulateur (500) comprenant :

   un premier mélangeur (510A) agencé pour recevoir et moduler un signal de porteuse en phase (ILO) par un signal d'information en phase (I_{IN}) pour produire une première composante modulée ;
   un deuxième mélangeur (510B) agencé pour recevoir et moduler un signal de porteuse en quadrature (QLO) par un signal d'information en quadrature (Q_{IN}) pour produire une seconde composante modulée ;
   un troisième mélangeur (510C) agencé pour recevoir et moduler le signal de porteuse en phase par le signal d'information en quadrature (Q_{IN}) pour produire une troisième composante modulée, dans lequel les troisièmes composantes modulées incluent une inversion de signal ;
   un quatrième mélangeur (510D) agencé pour recevoir et moduler le signal de porteuse en quadrature par le signal d'information en phase pour produire une quatrième composante modulée ;
   un premier somateur couplé aux premier et quatrième mélangeurs (510A, 510D), le premier somateur étant agencé pour recevoir et combiner les première et quatrième composantes modulées pour produire une composante modulée en phase ; et
   un second somateur couplé aux deuxième et troisième mélangeurs (510B, 510C), le second somateur étant agencé pour recevoir et combiner les deuxième et troisième composantes modulées pour produire une composante modulée en quadrature,

   dans lequel : chacun des signaux de porteuse en phase et en quadrature (ILO, QLO) est fourni en tant que signal différentiel.

2. Modulateur (500) selon la revendication 1, dans lequel les signaux de porteuse en phase et en quadrature sont déphasés de sensiblement 90° l'un par rapport à l'autre.

3. Modulateur (500) selon la revendication 1, dans lequel les mélangeurs sont mis en oeuvre par des multiplieurs à cellules de Gilbert.

4. Modulateur (500) selon la revendication 3, dans lequel les multiplieurs à cellules de Gilbert sont mis en oeuvre avec des transistors bipolaires.

5. Modulateur (500) selon la revendication 3, dans lequel les multiplieurs à cellules de Gilbert sont mis en oeuvre avec des transistors à effet de champ.

6. Modulateur (500) selon la revendication 3, dans lequel les sommateurs sont mis en oeuvre par les sorties croisées de multiplieurs à cellule de Gilbert.

7. Modulateur (500) selon la revendication 1, dans lequel les signaux de porteuse en phase et en quadrature sont produits en utilisant deux signaux de porteuse intermédiaires.

8. Modulateur (500) selon la revendication 7, dans lequel les deux signaux de porteuse intermédiaires sont à deux fréquences différentes.

9. Modulateur (500) selon la revendication 7, dans lequel les deux signaux de porteuse intermédiaires incluent un signal de porteuse IF et un signal de porteuse RF.

10. Modulateur (500) selon la revendication 1, dans lequel les mélangeurs et somateurs sont mis en oeuvre en utilisant une topologie de circuits empilés.

11. Emetteur (200) comprenant le modulateur de la revendication 1.

12. Procédé de modulation d'un signal d'information ayant une composante en phase et une composante en quadrature, le procédé comprenant :

   moduler un signal de porteuse en phase (ILO) par la composante en phase pour produire une première composante modulée ;
   moduler un signal de porteuse en quadrature (QLO) par la composante en quadrature pour produire une seconde composante modulée ;

moduler le signal de porteuse en phase (ILO) par la composante en quadrature pour produire une troisième composante modulée, la troisième composante modulée incluant une inversion de signal ;

moduler le signal de porteuse en quadrature (QLO) par la composante en phase pour produire une quatrième composante modulée ;

sommer les première et quatrième composantes modulées pour produire une composante modulée en phase ; et

sommer les deuxième et troisième composantes modulées pour produire une composante modulée en quadrature,

dans lequel chacun des signaux de porteuse en phase et en quadrature (ILO, QLO) est fourni en tant que signal différentiel.

**13.** Procédé selon la revendication 12, comprenant en outre :

additionner les composantes modulées en phase et en quadrature pour fournir un signal modulé.

**14.** Procédé selon la revendication 12, comprenant en outre :

inverser ou bien le signal de porteuse en phase (ILO) ou bien la composante en quadrature avant la modulation pour produire la troisième composante modulée.

**15.** Démodulateur (900) comprenant :

un premier mélangeur agencé pour recevoir et démoduler un signal modulé par un signal de porteuse en phase (ILO) pour produire une première composante démodulée ;

un deuxième mélangeur agencé pour recevoir et démoduler le signal modulé par un signal de porteuse en quadrature (QLO) pour produire une deuxième composante démodulée ;

un troisième mélangeur agencé pour recevoir et démoduler le signal modulé par un signal de porteuse en phase (ILO) pour produire une troisième composante démodulée ;

un quatrième mélangeur agencé pour recevoir et démoduler le signal modulé par un signal de porteuse en quadrature (QLO) pour produire une quatrième composante démodulée ;

un premier sommateur couplé aux premier et quatrième mélangeurs, le premier sommateur étant agencé pour recevoir et combiner les première et quatrième composantes démodulées pour produire un signal démodulé en phase ($I_{OUT}$); et

un second sommateur couplé aux deuxième et troisième mélangeurs, le second sommateur étant agencé pour recevoir et soustraire la troisième composante démodulée de la deuxième composante démodulée pour produire un signal démodulé en quadrature ($Q_{OUT}$),

dans lequel chacun des signaux de porteuse en phase et en quadrature (ILO, QLO) est fourni en tant que signal différentiel.

FIG. 1

EP 1 330 905 B1

FIG. 2

300

MODULATED SIGNAL

312

310A

I LO

$I_{IN}$

310B

Q LO

$Q_{IN}$

FIG. 3A

FIG. 3B

FIG. 4

EP 1 330 905 B1

FIG. 5

FIG. 6A

FIG. 6B

FIG. 7A

EP 1 330 905 B1

FIG. 7B

EP 1 330 905 B1

FIG. 8

EP 1 330 905 B1

$I_{OUT}$

$Q_{OUT}$

900

I LO —910A

910B— Q LO

—906

$V_{IN}$

GAIN STAGE

$I_{IN}$

FIG. 9

MIXING SIGNAL VS. LO AMPLITUDE

INPHASE MIXING FUNCTION
FOR I LO >> 2V$_T$

QUADRATURE MIXING FUNCTION
FOR VARIOUS Q LO VALUES

FIG. 10

**EP 1 330 905 B1**

**Patent documents cited in the description**

- US 5438301 A
- US 5705958 A
- US 5111155 A
- US 5412351 A
- US 4053882 A